# EUROPEAN PATENT SPECIFICATION

(11) **EP 3 560 708 B1**
(45) Date of publication and mention of the grant of the patent: **30.10.2024**
(21) Application number: 17885109.3
(22) Date of filing: 18.12.2017
(51) Int. Cl.: C08J 7/043, C08J 7/048

(54) **GAS BARRIER FILM**
GASBARRIERENFILM
FILM BARRIÈRE CONTRE LES GAZ

(30) Priority: 20.12.2016 JP 2016246593
(43) Date of publication of application: 30.10.2019
(73) Proprietor: Toppan Printing Co., Ltd., Tokyo 110-0016 (JP)
(72) Inventor: NISHIKAWA Takeshi, Tokyo 110-0016 (JP); ISHII Toshiya, Tokyo 110-0016 (JP); OMORI Haruka, Tokyo 110-0016 (JP)
(74) Representative: TBK
(86) International application number: PCT/JP2017/045375
(87) International publication number: WO 2018/117043

(56) References cited:
- JP-A- 2013 028 160
- JP-A- 2013 049 266
- JP-A- 2014 069 389
- US-A1- 2009 215 279
- US-A1- 2009 274 894
- US-A1- 2010 112 270

## Description

### [Technical Field]

The present invention relates to a gas barrier film.

### [Background Art]

Conventionally, various packaging materials having barrier properties against permeation of oxygen and moisture have been developed. In recent years, many proposals have been made for gas barrier films in which a nanoscale metal oxide film such as silicon oxide or aluminum oxide is formed on a plastic substrate.

When gas barrier films are used in, for example, displays, high transmission is required, and therefore aluminum foil is unsuitable for such use. In the field of food packaging, there is an increasing trend not to use aluminum foil, in terms of ease of recycling and usability of metal detectors, and gas barrier films including a metal oxide film are being promoted. For example, in PTL 1, gas barrier properties and light transmissivity are obtained with a gas barrier film using silicon oxide (SiOx), which is a metal oxide, as an inorganic deposition layer, without using aluminum foil.

### [Citation List]

### [Patent Literature]

PTL 1: JP 2014-148081 A

### [Summary of the Invention]

### [Technical Problem]

However, according to the research of the present inventors, in gas barrier films including a metal oxide film, inorganic deposition layers were less likely to obtain durability against forces, such as bending or stretching, and their barrier properties were sometimes impaired by an external force during bag-making, transportation, etc. Moreover, gas barrier films including a metal oxide film sometimes had variation in their gas barrier properties.

JP-A-2014069389 discloses a gas barrier film comprising a polymer film, an anchor coat layer comprising an acrylic polyol having carboxylic acid groups and polyisocyanate, and a metal oxide layer.

Even with the gas barrier film disclosed in PTL 1, there was variation in the gas barrier properties, and the resistance to an external force was not sufficient. An object of the present invention is to provide a gas barrier film including a metal oxide layer, the gas barrier film being capable of suppressing a reduction in barrier properties when an external force is applied, for example, during production or processing of the gas barrier film.

### [Solution to Problem]

The present invention provides a gas barrier film including a polymer film, an anchor coat layer, and a metal oxide layer. In the gas barrier film, the polymer film and the metal oxide layer are laminated with the anchor coat layer interposed therebetween. Moreover, the anchor coat layer has a thickness of 25 nm or more. The anchor coat layer is a layer containing an acrylic resin having an organic acid group, or a layer including a cured product of a composition containing an acrylic resin having an organic acid group. The anchor layer further comprises a polyisocyanate, the acrylic resin is an acrylic polyol resin and the mass ratio acrylic polyol resin/polyisocyanate is 2/8 or higher.

When an external force is applied, for example, during production or processing of the gas barrier film, a reduction in the barrier properties can be suppressed.

In the gas barrier film, the atomic ratio N/C of nitrogen to carbon, obtained by analyzing the anchor coat layer by X-ray photoelectron spectroscopy, is preferably in the range of 0 or more and less than 0.5. In the production of gas barrier films, laminates of a polymer film and an anchor coat layer are often wound in a roll shape and stored for a fixed period of time. During storage, blocking may occur between the anchor coat layer and the inside polymer film. When the blocked anchor coat layer is peeled from the polymer film during unwinding after storage, roughness occurs on the surface, and therefore a metal compound layer formed on the anchor coat layer becomes uneven, consequently reducing moisture permeability. However, because the anchor coat layer has a specific atomic ratio N/C, there is a tendency that blocking between the anchor coat layer and the polymer film mentioned above can be suppressed, and a reduction in moisture permeability due to such blocking can be prevented.

In the gas barrier film, the anchor coat layer is made of a cured product of a composition containing an acrylic resin having an organic acid group, the composition further contains a polyisocyanate, and the acrylic resin is an acrylic polyol resin. When the anchor coat layer is made of the above cured product, the adhesion with the polymer film or metal oxide layer tends to be improved. In the above composition, the ratio M_{A}/M_{I} of the content M_{A} of the acrylic polyol resin to the content M_{I} of the polyisocyanate is 2/8 or more by mass ratio. When the anchor coat layer is made of the above cured product, the adhesion with the polymer film or metal oxide layer tends to be improved.

In the gas barrier film, the thickness of the anchor coat layer may be less than 600 nm. When the thickness of the anchor coat layer is less than 600 nm, there is a tendency that the handling properties are good, and that cracks are less likely to be formed on the anchor coat layer. Moreover, because the metal oxide layer can be uniformly formed, a reduction in barrier properties is more easily suppressed.

In the gas barrier film, the metal oxide layer may contain Si atoms or Al atoms, and may be formed by vacuum deposition.

The gas barrier film preferably further includes a gas barrier covering layer. In this case, the gas barrier covering layer is preferably provided on the surface of the metal oxide layer on a side opposite to the anchor coat layer. Because the gas barrier includes a gas barrier covering layer, there is a tendency that the gas barrier properties are further improved.

### [Advantageous Effects of the Invention]

The present invention can provide a gas barrier film including a metal oxide layer provided by vacuum deposition, the gas barrier film being capable of suppressing a reduction in barrier properties when an external force is applied, for example, during production or processing of the gas barrier film.

### [Brief Description of the Drawings]

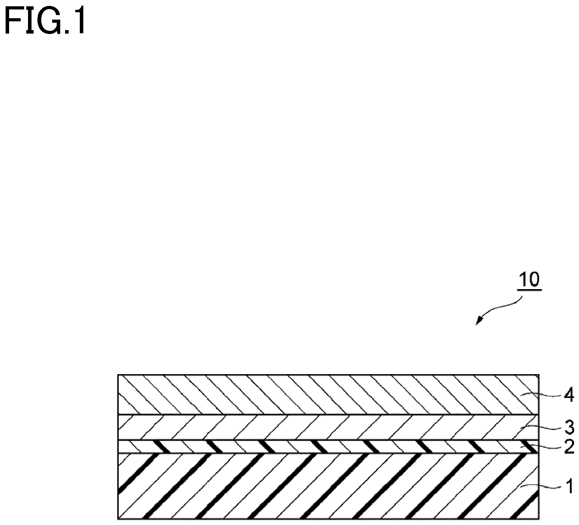

Fig. 1 is a schematic cross-sectional view of a gas barrier film according to one embodiment of the present invention.

### [Description of Embodiments]

Embodiments of the present invention are described in detail below. The present invention is not limited to the following embodiments.

### (Gas Barrier Film)

Fig. 1 is a schematic cross-sectional view of a gas barrier film according to one embodiment of the present invention. In Fig. 1, a gas barrier film 10 includes a polymer film 1, an anchor coat layer 2, a metal oxide layer 3, and a gas barrier covering layer 4. The polymer film 1, the anchor coat layer 2, the metal oxide layer 3, and the gas barrier covering layer 4 are laminated in this order.

The polymer film 1 (hereinafter also referred to as the "substrate 1") can be, for example, a film made of polyethylene terephthalate, polybutylene terephthalate, polyethylene naphthalate, nylon, polycarbonate, polypropylene, triacetyl cellulose, polycycloolefin, or the like; however, it is not limited thereto. The thickness of the substrate 1 is not limited, but is about 3 to 100 µm, for example.

The polymer film may contain additives, such as antistatic agents, ultraviolet absorbers, plasticizers, and lubricants, as necessary. Further, the surface of the substrate 1 may be subjected to modification treatment, such as corona treatment, flame treatment, plasma treatment, or easy adhesion treatment. The surface of the substrate 1 contributes to denseness or adhesion in the initial growth stage of vacuum deposition of a metal oxide layer, described later, and is desirably smooth.

The anchor coat layer 2 is a layer containing an acrylic resin having an organic acid group, or a layer including a cured product of a composition containing an acrylic resin having an organic acid group. The polymer film 1 and the metal oxide layer 3 are laminated with the anchor coat layer 2 interposed therebetween. Because the acrylic resin has an organic acid group, adhesion between the anchor coat layer 2 and the polymer film 1 or the metal oxide layer 3 can be easily obtained, and a reduction in moisture permeability is more likely to be suppressed when an external force is applied by stretching or the like. Examples of organic acid groups include a carboxyl group, a sulfonic acid group, and the like. The organic acid group is preferably a group reactive with hydroxyl groups, and more preferably a carboxyl group.

The acid value of the acrylic resin having an organic acid group can be 1 to 30 KOHmg/g. Moreover, the weight average molecular weight of the acrylic resin having an organic acid group is about 1,000 to 100,000, for example.

The acrylic resin having an organic acid group can be obtained by, for example, mixing an acrylic resin having a hydroxyl group with a dicarboxylic acid to react the hydroxyl group in the acrylic resin with one carboxyl group in the dicarboxylic acid. In this case, the other carboxyl group in the dicarboxylic acid is introduced as an organic acid group into the acrylic resin. The present invention can be carried out even if both carboxyl groups in some dicarboxylic acids are reacted with the hydroxyl group in the acrylic resin. Examples of dicarboxylic acids include oxalic acid, malonic acid, succinic acid, glutaric acid, adipic acid, pimelic acid, suberic acid, azelaic acid, sebacic acid, phthalic acid, isophthalic acid, terephthalic acid, and the like.

The atomic ratio (N/C) of nitrogen (N) to carbon (C) in the anchor coat layer is preferably in the range of 0 or more and less than 0.5. The atomic ratio N/C can be determined by analyzing the anchor coat layer by X-ray photoelectron spectroscopy. When a gas barrier film is produced by a roll-to-roll process, in terms of the production process thereof, when an anchor coat layer is formed on a polymer film, a laminate including the polymer film and the anchor coat layer is wound in a roll shape, and stored in the rolled state for a fixed period of time. In this case, blocking may occur between the anchor coat layer and the inside polymer film layer. Blocking is likely to occur due to, for example, tight-winding of the roll and fixing for a long period of time. However, when the atomic ratio N/C is less than 0.5, there is a tendency that blocking between the anchor coat layer and the polymer film can be suppressed, and the production of the barrier film can be facilitated. If blocking occurs, the metal oxide layer to be laminated is less likely to exhibit moisture barrier properties; however, such a reduction can be suppressed by controlling the above atomic ratio. Moreover, in terms of further improving the moisture barrier properties, the atomic ratio N/C may be 0.40 or less, and more preferably may be 0.35 or less. In contrast, the atomic ratio N/C may be 0.05 or more, and more preferably may be 0.10 or more, in terms of further improving the moisture barrier properties after an external force is applied.

When the anchor coat layer is a layer including a cured product of a composition containing an acrylic resin having an organic acid group, the curing method is ultraviolet curing, electron-ray curing, or heat curing, but is not limited thereto. When the curing method is heat curing, it is advantageous to apply the composition in the form of a thin film at a high speed. In addition to the above acrylic resin, the above composition preferably contains a curing agent that can cure the acrylic resin. The curing agent is selected from various curing agents according to the curing method. When the curing method is heat curing, the anchor coat layer is formed by applying the composition to the polymer film 1, and heating the coating film for drying and curing. The heating temperature is 50 to 200°C, for example; and the heating time is about 10 seconds to 10 minutes, for example.

The above composition may be a coating solution cured with one solution, and a coating solution cured with two solutions. When the above composition is a coating solution cured with two solutions, the above acrylic resin preferably has a hydroxyl group in addition to an organic acid group mentioned above, and more preferably has two or more hydroxyl groups. Such an acrylic resin can also be called an acrylic polyol resin. The above composition further contains, as a curing agent, a compound having a group reactive with hydroxyl groups mentioned above. The group reactive with hydroxyl groups is an isocyanate group. The curing agent is a polyisocyanate.

The polyisocyanate may be an aromatic polyisocyanate or an aliphatic polyisocyanate. The polyisocyanate used herein is desirably a polyisocyanate prepolymer, in terms of operational safety.

The ratio of the content of the acrylic resin having an organic acid group to the content of the curing agent in the above composition can have various values depending on the obtained characteristics, such as adhesion or moisture permeability. The ratio M_{A}/M_{I} of the content M_{A} of the acrylic polyol resin to the content M_{I} of the polyisocyanate is, by mass ratio, 2/8 or more preferably 4/6 or more, andovonmore preferably 6/4 or more. When the ratio M_{A}/M_{I} is 2/8 or more, there is a tendency that blocking between the anchor coat layer 2 and the polymer film 1 can be suppressed. Moreover, the ratio M_{A}/M_{I} may be, by mass ratio, 9/1 or less, and may be 8/2 or less. When the ratio M_{A}/M_{I} is within the above range, there is a tendency that the gas barrier film can achieve much more excellent moisture permeability. The above composition may further contain other resins and additives, such as solvents and silane coupling agents.

The anchor coat layer can further contain other resins and additives, such as solvents and silane coupling agents. The above anchor coat layer is formed by applying a composition containing an acrylic resin having an organic acid group to the polymer film 1, and heating the coating film for drying. The coating method and the heating method are same as those described above. As the acrylic resin having an organic acid group, those mentioned above can be similarly used.

The thickness of the anchor coat layer is 25 nm or more. This suppresses the brittleness of the layer, and excellent adhesion is likely to be obtained. Further, a uniform anchor coat layer is likely to be obtained, and durability is likely to be improved. The thickness of the anchor coat layer is preferably 50 nm or more, more preferably 100 nm or more, and even more preferably 200 nm or more. When the thickness of the anchor coat layer is increased, a reduction in moisture barrier properties when an external force, such as stretching, is applied can be further suppressed. The thickness of the anchor coat layer may be less than 600 nm. When the thickness of the anchor coat layer is less than 600 nm, there is a tendency that the handling properties are good, and that cracks are less likely to be formed on the anchor coat layer. Moreover, because the metal oxide layer can be uniformly formed, a reduction in barrier properties is more easily suppressed.

The metal oxide layer 3 is a layer including a metal oxide, and can contain at least one atom selected from the group consisting of Si, Al, Mg, Sn, Ti, and In. In terms of barrier properties, Si atoms or Al atoms is preferably contained. The metal oxide layer 3 can be a layer incuding a metal oxide, such as so-called SiOₓ or AlOₓ; however, there is no problem if nitrogen and carbon atoms are contained. The metal oxide layer 3 is preferably a layer including SiOₓ in terms of gas barrier properties, and is preferably a layer including AlOₓ in terms of productivity. The gas barrier film 10 according to the present embodiment has excellent durability to external force, such as bending or stretching, even though it includes a metal oxide layer; and a reduction in barrier properties when such external force is applied can be suppressed.

The metal oxide layer 3 can be formed by vacuum deposition, for example. The metal oxide layer 3 may include a single layer or multiple layers. When the metal oxide layer 3 includes multiple layers, at least one of the multiple layers can be formed by vacuum deposition. When the metal oxide layer 3 is formed by vacuum deposition, the resistance to external force may be reduced. However, according to the gas barrier film of the present embodiment, even when the metal oxide layer 3 is formed by vacuum deposition, there is a tendency that a reduction in the resistance to such external force can be sufficiently suppressed. A physical vapor deposition method or a chemical vapor deposition method can be employed for vacuum deposition. Examples of the physical vapor deposition method include, but are not limited to, a vacuum deposition method, a sputtering deposition method, an ion plating method, and the like. Examples of the chemical vapor deposition method include, but are not limited to, a thermal CVD method, a plasma CVD method, an optical CVD method, and the like.

Preferably used in the present embodiment are particularly a resistance heating vacuum deposition method, an EB (electron beam) heating vacuum deposition method, an induction heating vacuum deposition method, a sputtering method, a reactive sputtering method, a dual magnetron sputtering method, a plasma chemical vapor deposition method (PECVD method), and the like.

When plasma is used, examples of the plasma generation method include a DC (direct current) method, a RF (radio frequency) method, a MF (middle frequency) method, a DC pulse method, a RF pulse method, a DC+RF superposition method, and the like.

In the case of a sputtering method, a negative potential gradient occurs in a target, which is a cathode, and Ar⁺ ions receive potential energy and collide with the target. Even when plasma is generated, sputtering cannot be performed unless a negative self-bias potential is generated. Accordingly, auto-bias does not occur in MW (micro wave) plasma, which is not suitable for sputtering. However, in a PECVD method, chemical reaction, deposition, and like processes proceed using the gas-phase reaction in plasma, and film production is possible without auto-bias; thus, MW plasma can be used.

The thickness of the metal oxide layer 3 is preferably in the range of 3 nm or more and 100 nm or less. When the thickness of the metal oxide layer 3 is 3 nm or more, moisture barrier properties can be easily obtained. Moreover, when the thickness of the metal oxide layer 3 is 100 nm or less, there is a tendency that a reduction in the moisture barrier properties caused by cracking due to the increase in internal stress can be suppressed. Furthermore, when the thickness of the metal oxide layer 3 is 100 nm or less, cost can be reduced, for example, due to a reduction in the amount of material used, and a reduction in the time for film formation, which is preferable from an economic viewpoint.

The gas barrier covering layer 4 is provided by, for example, applying a coating liquid to the surface of the metal oxide layer 3 on a side opposite to the anchor coat layer 2, and heating the coating liquid. The coating method can be a known method. Specific examples of the coating method include wet film-forming methods using a gravure coater, a dip coater, a reverse coater, a wire bar coater, or a die coater. The heating temperature is about 80 to 250°C, for example; and the heating time is about 3 seconds to 10 minutes, for example.

The above coating liquid preferably contains polyvinyl alcohol. That is, the gas barrier covering layer 4 preferably contains polyvinyl alcohol. Examples of the polyvinyl alcohol include fully saponified products, intermediate saponified products, or partially saponified products of compounds, such as polyvinyl acetate. In terms of further imparting water resistance, the polyvinyl alcohol is desirably the above fully saponified product. The molecular weight of the polyvinyl alcohol is about 500 to 3500, and desirably less than 2500 in order to reduce viscosity for coating suitability.

The gas barrier covering layer 4 may contain a binder, in order to further improve the barrier properties. When the gas barrier covering layer 4 contains a binder, the binder is preferably an aqueous material because the polyvinyl alcohol is water soluble. Specific examples of the binder include water dispersions of polyacrylic acid, polyurethane, acrylic resin, polyester resin, or the like; metal oxides using a metal precursor obtained by a sol-gel method; and the like.

Moreover, the gas barrier covering layer 4 may contain, if necessary, additives, such as leveling agents, antifoaming agents, ultraviolet absorbers, antioxidants, silane coupling agents, and metal chelating agents.

The thickness of the gas barrier covering layer 4 is preferably 50 nm to 1000 nm, and more preferably 100 nm to 600 nm. When the thickness of the gas barrier covering layer 4 is 50 nm or more, a uniform film is likely to be formed. When the thickness of the gas barrier covering layer 4 is 1000 nm or less, there is a tendency that the occurrence of cracking or curling can be suppressed.

The present embodiment explains a form in which the gas barrier covering layer 4 is provided in order to obtain more excellent gas barrier properties; however, the gas barrier covering layer is not necessarily provided.

The gas barrier film described above is useful for packaging materials for food, beverages, and drugs, as well as emitter protective sheets in light-emitting units of information display devices etc.

For example, a print layer, an intermediate layer, a heat seal layer, etc., can be laminated on the surface of the gas barrier film 10 on the side of the gas barrier covering layer 4 to thereby form a packaging material. The print layer is formed for practical use as a packaging material. The print layer is a layer composed of ink containing a binder resin (e.g., a urethane-based binder resin, an acrylic-based binder resin, a nitrocellulose-based binder resin, a rubber-based binder resin, or a vinyl chloride-based binder resin) and additives, such as various pigments, extender pigments, plasticizers, drying agents, and stabilizers. Characters, picture patterns, etc., are formed on the print layer. Usable examples of the formation (lamination) method include printing methods, such as an offset printing method, a gravure printing method, and a silk screen printing method, as well as coating methods, such as roll coating, knife edge coating, and gravure coating. The thickness of the print layer is 0.1 to 2.0 µm, for example.

The intermediate layer is provided to increase bag-breaking strength during boiling and retort sterilization. In terms of mechanical strength and thermal stability, the intermediate layer is selected from a biaxially-oriented nylon film, a biaxially-oriented polyethylene terephthalate film, and a biaxially-oriented polypropylene film. The thickness of the intermediate layer is selected depending on the material, required quality, or the like, and is 10 to 30 µm, for example. The formation method is, for example, a dry laminate method that bonds together films using an adhesive, such as a two-component curable urethane-based resin.

The heat seal layer is provided as a sealing layer when a bag-like packaging body is formed. Usable examples of the heat seal layer include films including resins, such as polyethylene, polypropylene, an ethylene-vinyl acetate copolymer, an ethylene-methacrylic acid copolymer, an ethylene-methacrylic acid ester copolymer, an ethylene-acrylic acid copolymer, an ethylene-acrylic ester copolymer, and a metal crosslinked product thereof. The thickness of the heat seal layer is selected depending on the purpose, and is 15 to 200 µm, for example. The formation method is, for example, a dry laminate method that bonds together films forming the heat seal layer, using an adhesive, such as a two-component curable urethane-based resin.

Examples of light-emitting units of information display devices mentioned above include backlight units of liquid crystal displays, electroluminescent light-emitting units, and the like.

The backlight unit includes, for example, a light source and a phosphor layer, and further includes a pair of gas barrier films 10 arranged to sandwich and seal the phosphor layer. Light from the light source passes through the phosphor layer, and the wavelength of part of the light is converted. Light with a converted wavelength and light with an unconverted wavelength are mixed to form white light.

The phosphor layer contains a binder resin and a phosphor dispersed in the binder resin. Phosphors can convert the wavelength of light; however, this function is likely to be lost upon contact with oxygen, moisture, etc. However, such a reduction in the function of the phosphor can be suppressed because the phosphor layer is sandwiched between the gas barrier films 10. For example, a photosensitive resin is used as the binder resin.

The electroluminescent light-emitting unit includes, for example, an electroluminescent emitter layer and gas barrier films 10. The electroluminescent light-emitting unit is obtained by, for example, sandwiching and sealing an electrode element including a transparent electrode layer, an electroluminescent emitter layer, a dielectric layer, and a back electrode layer, by the gas barrier films 10. A reduction in the function of the emitter can be suppressed because the electroluminescent emitter layer is sandwiched between the gas barrier films 10.

### [Examples]

The present invention is described in detail below with reference to Examples; however, the present invention is not limited thereto.

### <Production of Gas Barrier Film>

### (Example 1) - not part of the invention

A gas barrier film was produced by a roll-to-roll process in the following manner. First, a 12-µm-thick polyethylene terephthalate film substrate (a polymer film, P60 (trade name), produced by Toray Industries, Inc.) was mounted in an unwinding device, a transfer device, and a winding device. Next, phthalic acid was added to a solution of an acrylic polyol resin that did not have a carboxyl group, and these were reacted, thereby obtaining a solution of an acrylic polyol resin having a carboxyl group. The above resin solution was applied by a gravure coating method to the polyethylene terephthalate film substrate under conveyance. The coating film was dried by heating at 120°C for 10 seconds, thereby forming an anchor coat layer having a thickness of 50 nm. The laminate obtained by forming the anchor coat layer on the polyethylene terephthalate film substrate was wound, and stored in a rolled state.

The rolled laminate after storage was mounted in the unwinding device, the transfer device, and the winding device. An AlOₓ film (metal oxide layer) having a film thickness of 10 nm was formed by a vapor deposition method on the anchor coat layer of the laminate under conveyance. Vapor deposition was performed by evaporating an aluminum ingot by electron beam heating using an electron-beam heating type vacuum deposition apparatus, and introducing oxygen at a pressure of 1.2 × 10⁻² Pa.

A coating liquid obtained by mixing a hydrolyzate of tetraethoxysilane and polyvinyl alcohol at a mass ratio of 1/1 was applied to the AlOₓ film by a bar-coating method. The coating film was dried by heating at 120°C for 1 minute, thereby forming a gas barrier covering layer having a thickness of 400 nm. The gas barrier film of Example 1 in which a polymer film, an anchor coat layer, a metal oxide layer, and a gas barrier covering layer were laminated in this order was produced in the above manner.

### (Example 2)

Phthalic acid was added to a solution of an acrylic polyol resin that did not have a carboxyl group, and these were reacted, thereby obtaining a solution of an acrylic polyol resin having a carboxyl group, which was the same as that of Example 1. Next, the above resin solution was mixed with a polyisocyanate to prepare a mixture so that the amount of polyisocyanate was 3 parts by mass relative to 7 parts by mass of acrylic polyol resin. A gas barrier film of Example 2 was produced in the same manner as in Example 1, except that the above mixture was applied, in place of the acrylic polyol resin solution having a carboxyl group applied in Example 1, to a polyethylene terephthalate film substrate to form an anchor coat layer.

### (Example 3)

A gas barrier film of Example 3 was produced in the same manner as in Example 2, except that as the metal oxide layer, a SiOₓ film was formed in place of the AlOₓ film, and the film thickness thereof was set to 30 nm.

### (Example 4)

A gas barrier film of Example 4 was produced in the same manner as in Example 2, except that the film thickness of the anchor coat layer was changed to 400 nm.

### (Example 5)

A gas barrier film of Example 5 was produced in the same manner as in Example 2, except that a mixture was prepared so that the amount of polyisocyanate was 6 parts by mass relative to 4 parts by mass of acrylic polyol resin.

### (Example 6)

A gas barrier film of Example 6 was produced in the same manner as in Example 2, except that a mixture was prepared so that the amount of polyisocyanate was 8 parts by mass relative to 2 parts by mass of acrylic polyol resin.

### (Comparative Example 1)

A gas barrier film of Comparative Example 1 was produced in the same manner as in Example 2, except that a solution of an acrylic polyol resin that did not have a carboxyl group, which was the same as one used in Example 2 (one used to produce an acrylic polyol resin having a carboxyl group in Example 2), was mixed with a polyisocyanate to prepare a mixture so that the amount of polyisocyanate was 5 parts by mass relative to 5 parts by mass of acrylic polyol resin.

### (Comparative Example 2)

A gas barrier film of Comparative Example 2 was produced in the same manner as in Example 2, except that a solution including only the same polyisocyanate as that used in Example 2 was applied, in place of the above mixture, to a polyethylene terephthalate film substrate to form an anchor coat layer.

### (Comparative Example 3)

A gas barrier film of Comparative Example 3 was produced in the same manner as in Example 2, except that a mixture was prepared so that the amount of polyisocyanate was 5 parts by mass relative to 5 parts by mass of acrylic polyol resin, and an anchor coat layer was formed so that that the thickness thereof was 10 nm.

### <Evaluation of Gas Barrier Film>

### (N/C Ratio)

The surface of each of the laminates obtained in the Examples and Comparative Examples (laminates of a polyethylene terephthalate film substrate and an anchor coat layer) on the side of the anchor coat layer was analyzed using an X-ray photoelectron spectrometer (JPS-9030, produced by JEOL Ltd.), and X-ray photoelectron spectroscopy spectra were obtained. Analysis was carried out using non-monochromatic MgKα (1253.6 eV) as an X-ray source while setting the X-ray output to 100 W (10 kV-10 mA). The N/C ratio (atomic ratio N/C) was determined from the ratio of the total area of N1s peaks to the total area of C1s peaks (area ratio of the total area of N1s peaks to the total area of C1s peaks) in the X-ray photoelectron spectroscopy spectra. The N/C ratio was determined while setting the relative sensitivity factors to 2.28 for O1s, 1.61 for N1s, and 1.00 for C1s.

### (Blocking Resistance)

The rolled laminates (laminates of a polyethylene terephthalate film substrate and an anchor coat layer) of the Examples and Comparative Examples wound at a length of 50 m were stored in a thermostatic chamber at a temperature of 40°C for a day. Thereafter, the laminates were unwound. When the laminates were easily peeled from each other during unwinding thereof, and it could be determined that blocking did not occur, this case was evaluated as "A"; and when there was a problem, during unwinding of the laminates, that, for example, the laminates were not easily peeled from each other, a loud peeling sound was made during peeling, or part of the layers constituting one laminate was transferred to the other laminate, and it could be determined that blocking occurred, these cases were evaluated as "B." Table 1 shows the evaluation results of blocking resistance.

### (Adhesion)

The gas barrier films obtained in the Examples and Comparative Examples were each cut into thin strips with a width of 1 cm, and the gas barrier covering layer side of each gas barrier film was bonded to a LLDPE (linear low density polyethylene) film using an adhesive. The polymer film side of the thin strip-like gas barrier film was peeled from the LLDPE film using a Tensilon tensile tester (produced by Orientec Co., Ltd.) at a rate of 300 mm/min so that the polymer film and the LLDPE film were pulled in opposite direction. Then, the strength required for peeling was measured. The adhesion (adhesion between the anchor coat layer and the polymer film or metal oxide layer) of each gas barrier film was thereby evaluated according to the following criteria. Table 1 shows the evaluation results of adhesion.
A: The peel strength was 2 N/cm or more.
B: The peel strength was less than 2 N/cm.

### (Moisture Permeability)

The gas barrier films obtained in the Examples and Comparative Examples were each cut to a size of 260 mm × 130 mm (MD × TD). The cut gas barrier film was attached to a stretching device so that the length of the stretched part (in the MD direction) was 200 mm, and an initial tension of 1.2 kgf was applied in the MD direction using a spring balance. The gas barrier film was pulled to a stretch ratio of 2% in the MD direction at a stage movement speed of 0.1 mm/sec. After the film was maintained in a pulled state for 1 minute, the stage was moved to the initial position at the same speed. Gas barrier films after stretching were obtained as described above.

The moisture permeability of the gas barrier films obtained in the Examples and Comparative Examples before and after stretching was measured by a method according to the infrared sensor method of JIS K 7129. Table 1 shows the measurement results of moisture permeability before and after stretching. The moisture permeability was measured using a moisture permeability measuring device (trade name: Permatran, produced by MOCON). The temperature of the permeation cell was set to 40°C, and the relative humidity of the high humidity chamber was set to 90% RH.

**[Table 1]**

| | Anchor coat layer | | | Metal oxide layer | Blocking resistance | Adhesion | Moisture permeability (g/m²·day) | |
|---|---|---|---|---|---|---|---|---|
| | Organic acid group | N/C ratio | Film thickness (nm) | Vapor deposition material | | | Before stretching | After stretching |
| Example 1 | Carboxyl group | 0.00 | 50 | AlOₓ | A | A | 1.5 | 9.5 |
| Example 2 | Carboxyl group | 0.11 | 50 | AlOₓ | A | A | 0.9 | 8.7 |
| Example 3 | Carboxyl group | 0.11 | 50 | SiOₓ | A | A | 0.5 | 0.8 |
| Example 4 | Carboxyl group | 0.11 | 400 | AlOₓ | A | A | 1.0 | 6.0 |
| Example 5 | Carboxyl group | 0.20 | 50 | AlOₓ | A | A | 1.0 | 6.5 |
| Example 6 | Carboxyl group | 0.35 | 50 | AlOₓ | A | A | 1.4 | 6.1 |
| Comparative Example 1 | None | 0.15 | 50 | AlOₓ | A | B | 1.5 | 29.0 |
| Comparative Example 2 | - | 0.57 | 50 | AlOₓ | B | A | 6.7 | - |
| Comparative Example 3 | Carboxyl group | 0.15 | 10 | AlOₓ | A | B | 6.2 | - |

As shown in Table 1, gas barrier films having excellent adhesion and excellent barrier properties before and after stretching were produced in Examples 1 to 6. In Comparative Examples 2 and 3, the moisture permeability values of the gas barrier films before stretching were clearly higher than the moisture permeability values of the gas barrier films of Examples 1 to 6 before stretching. Accordingly, the moisture permeability after stretching was not measured in Comparative Examples 2 and 3.

### [Reference Signs List]

- 1: Polymer film
- 2: Anchor coat layer
- 3: Metal oxide layer
- 4: Gas barrier covering layer
- 10: Gas barrier film

## Claims

1. A gas barrier film comprising a polymer film, an anchor coat layer, and a metal oxide layer; wherein
the polymer film and the metal oxide layer are laminated with the anchor coat layer interposed therebetween,
the anchor coat layer has a thickness of 25 nm or more, and
the anchor coat layer is a layer containing an acrylic resin having an organic acid group, or a layer comprising a cured product of a composition containing an acrylic resin having an organic acid group, the composition further contains a polyisocyanate, and the acrylic resin is an acrylic polyol resin,
wherein a mass ratio M_{A}/M_{I} of the content M_{A} of the acrylic polyol resin to the content M_{I} of the polyisocyanate in the composition is 2/8 or more.

2. The gas barrier film according to claim 1, wherein the atomic ratio N/C of nitrogen to carbon, obtained by analyzing the anchor coat layer by X-ray photoelectron spectroscopy and measured as specified in the description, is in a range of 0 or more and less than 0.5.

3. The gas barrier film according to claim 1 or 2, wherein the anchor coat layer has a thickness of less than 600 nm.

4. The gas barrier film according to any one of claims 1 to 3, wherein the metal oxide layer contains Si atoms or Al atoms, and is formed by vacuum deposition.

5. The gas barrier film according to any one of claims 1 to 4, further comprising a gas barrier covering layer; wherein
the gas barrier covering layer is provided on a surface of the metal oxide layer on a side opposite to the anchor coat layer.

## Patentansprüche

1. Gas-Barrierefolie, umfassend einen Polymerfolie, eine Verankerungsüberzugsschicht und eine Metalloxidschicht, wobei
der Polymerfilm und die Metalloxidschicht laminiert sind, wobei die Verankerungsüberzugsschicht dazwischen angeordnet ist,
die Verankerungsüberzugsschicht eine Dicke von 25 nm oder mehr aufweist, und
die Verankerungsüberzugsschicht eine Schicht ist, die ein Acrylharz mit einer organischen Säuregruppe enthält, oder eine Schicht, die ein gehärtetes Produkt einer Zusammensetzung umfasst, die ein Acrylharz mit einer organischen Säuregruppe enthält, wobei die Zusammensetzung ferner ein Polyisocyanat enthält und das Acrylharz ein Acrylpolyolharz ist,
wobei ein Masseverhältnis M_{A}/M_{I} des Gehalts M_{A} des Acrylpolyolharzes zu dem Gehalt M_{I} des Polyisocyanats in der Zusammensetzung 2/8 oder mehr beträgt.

2. Gas-Barrierefolie nach Anspruch 1, wobei das Atomverhältnis N/C von Stickstoff zu Kohlenstoff, das durch Analyse der Verankerungsüberzugsschicht mittels Röntgenphotoelektronenspektroskopie erhalten und wie in der Beschreibung angegeben gemessen wird, in einem Bereich von 0 oder mehr und weniger als 0,5 liegt.

3. Gas-Barrierefolie nach Anspruch 1 oder 2, wobei die Verankerungsüberzugsschicht eine Dicke von weniger als 600 nm aufweist.

4. Gas-Barrierefolie nach einem der Ansprüche 1 bis 3, wobei die Metalloxidschicht Si- oder Al-Atome enthält und durch Vakuumabscheidung gebildet ist.

5. Gas-Barrierefolie nach einem der Ansprüche 1 bis 4, die ferner eine Gas-Barrieredeckschicht umfasst; wobei
die Gas-Barrierefolie auf einer Oberfläche der Metalloxidschicht auf einer Seite gegenüber der Verankerungsüberzugsschicht vorgesehen ist.

## Revendications

1. Film barrière aux gaz comprenant un film polymère, une couche de revêtement d'ancrage et une couche d'oxyde métallique ; dans lequel
le film polymère et la couche d'oxyde métallique sont laminés, la couche de revêtement d'ancrage étant interposée entre les deux,
la couche de revêtement d'ancrage a une épaisseur de 25 nm ou plus, et
la couche de revêtement d'ancrage est une couche contenant une résine acrylique ayant un groupe acide organique, ou une couche comprenant un produit durci d'une composition contenant une résine acrylique ayant un groupe acide organique, la composition contient en outre un polyisocyanate, et la résine acrylique est une résine polyol acrylique,
dans lequel un rapport de masse M_{A}/M_{I} de la teneur M_{A} de la résine de polyol acrylique à la teneur M_{I} du polyisocyanate dans la composition est de 2/8 ou plus.

2. Film barrière aux gaz selon la revendication 1, dans lequel le rapport atomique N/C de l'azote au carbone, obtenu en analysant la couche de revêtement d'ancrage par spectroscopie photoélectronique à rayons X et mesuré comme spécifié dans la description, est compris entre 0 ou plus et moins de 0,5.

3. Film barrière aux gaz selon la revendication 1 ou 2, dans lequel la couche de revêtement d'ancrage a une épaisseur inférieure à 600 nm.

4. Film barrière aux gaz selon l'une des revendications 1 à 3, dans lequel la couche d'oxyde métallique contient des atomes de Si ou des atomes d'AI, et est formée par dépôt sous vide.

5. Film barrière aux gaz selon l'une des revendications 1 à 4, comprenant en outre une couche de recouvrement de la barrière aux gaz ; dans lequel
la couche de recouvrement de la barrière aux gaz est fournie sur une surface de la couche d'oxyde métallique sur un côté opposé à la couche de revêtement d'ancrage.
